**Europäisches Patentamt**

(19) **European Patent Office**

**Office européen des brevets**

(11) Publication number : **0 375 108 B1**

# (12) EUROPEAN PATENT SPECIFICATION

(45) Date of publication of patent specification :
30.11.94 Bulletin 94/48

(51) Int. Cl.⁵ : **H01L 43/08**

(21) Application number : **89307122.5**

(22) Date of filing : **13.07.89**

(54) **Indium arsenide magnetoresistor.**

(30) Priority : **23.12.88 US 289634**

(43) Date of publication of application :
**27.06.90 Bulletin 90/26**

(45) Publication of the grant of the patent :
**30.11.94 Bulletin 94/48**

(84) Designated Contracting States :
**DE FR GB IT NL SE**

(56) References cited :
**US-A- 3 898 359**
**US-A- 4 568 905**

(72) Inventor : **Heremans, Joseph P.**
**2640 Lanergan**
**Troy MI 48084 (US)**
Inventor : **Partin, Dale L.**
**37728 Alper Drive**
**Sterling Heights MI 48077 (US)**

(74) Representative : **Denton, Michael John et al**
**Patent Section**
**1st Floor**
**Gideon House**
**28 Chapel Street**
**Luton Bedfordshire LU1 2SE (GB)**

(73) Proprietor : **GENERAL MOTORS CORPORATION**
**General Motors Building**
**3044 West Grand Boulevard**
**Detroit Michigan 48202 (US)**

**EP 0 375 108 B1**

## Description

### Field of the Invention

This invention relates to magnetic field sensors as specified in the preamble of claim 1, for example as described by S.Kataoka in "Recent development of Magnetoresistive Devices and Applications," Circulars of Electrotechnical Laboratory No.182, Agency of Industrial Science and Technology, Tokyo (December 1974), and more particularly to improved thin film magnetoresistors and to methods of making such a magnetoresistor.

### Background of the Invention

In the past, magnetoresistors were believed to be best formed from high carrier mobility semiconductive material in order to get the highest magnetic sensitivity. Hence, the focus was on making magnetoresistors from bulk materials that were thinned down or on films having sufficient thickness to exhibit a high average mobility.

A sensor in accordance with the present invention is characterised by the features specified in the characterising portion of claim 1.

The inventors have found a new way to approach making magnetoresistors. The inventors have found that if a thin enough film of indium arsenide is formed, and if an accumulation layer-like characteristic is provided in the film, an extremely enhanced magnetoresistor can be formed with such a material. The inventors believe that an accumulation layer is inherently provided in an indium arsenide film when it is exposed to air. Tests indicate that the properties of the accumulation layer relevant to magnetic sensitivity can dominate over those of the remainder of the film, if the remainder of the film is thin enough.

### Summary of the Invention

From the foregoing, it is apparent that this invention involves a magnetoresistor formed in a film of indium arsenide having an inherently formed accumulation layer of current carriers, and in which the magnetic change in conductivity of the accumulation layer is not masked by conductivity of the balance of the film. The accumulation layer can be of the same conductivity type as that of the indium arsenide film or of opposite conductivity type. A opposite conductivity type accumulation layer is also referred to as an inversion layer but is considered to be within the scope of the phrase "accumulation layer" as used in this patent application.

This invention also provides new methods of making indium arsenide magnetoresistors.

### Description of the Drawings

Figure 1A is a schematic view of a magnetoresistor, showing its electrical current flow lines when no magnetic field is applied to it.

Figure 1B is a schematic view of a magnetoresistor, showing how the electrical current flow lines shown in Figure 2A are re-directed in the plane of a major surface of the magnetoresistor when a magnetic field is applied perpendicular to that surface.

Figure 2 is an isometric view showing a magnetoresistor having two integral sensing areas electrically in parallel.

Figure 3 is a three-dimensional or contour plot showing the change of electrical resistance in a single element larger band gap semi-conductor magnetoresistor with changes in temperature and magnetic field strength.

Figure 4 is a two-dimensional plot of the fractional magnetoresistance over a wider temperature range than shown in Figure 3.

Figure 5 is a two-dimensional plot showing change in resistance with no magnetic field applied over a wider temperature range than shown in Figure 3.

Figure 6 is an elevational view showing a semi-conductor film in a pattern for providing a series-connected plurality of sensing areas integrated in a single magnetoresistor.

Figure 7A is an elevational view showing a metallization pattern for superposition on the Figure 6 pattern.

Figure 7B is an elevational view showing the Figure 7A metallization pattern superimposed on the Figure 6 semi-conductor pattern to delineate the plurality of sensing areas.

Figure 8 is a three-dimensional or contour plot showing the change of electrical resistance of a multiple sensing area magnetoresistor such as shown in Figure 7A.

## Description of the Preferred Embodiments

A typical magnetoresistor element consists of a slab of semi-conductor, typically rectangular in shape, through which a current is passed. Such a magnetoresistor is described by S. Kataoka in "Recent development of Magnetoresistive Devices and Applications", Circulars of Electrotechnical Laboratory No. 182, Agency of Industrial Science and Technology, Tokyo (December 1974).

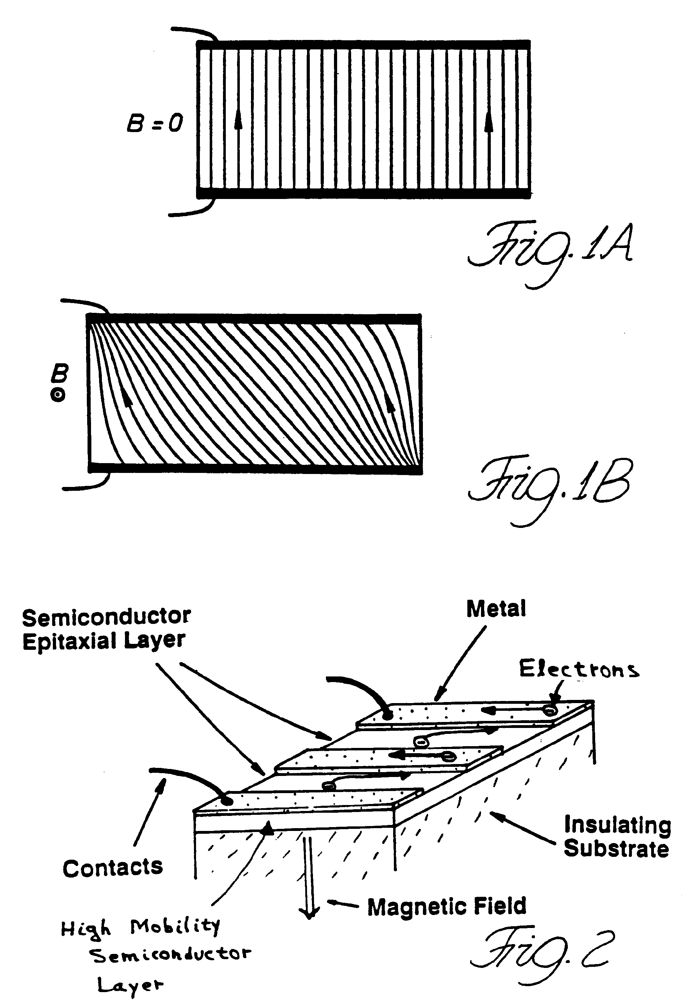

In the absence of a magnetic field, the current lines go from one injecting electrode to the other in parallel lines (see Figure 1A). This flow is between electrodes along the top and bottom edges of the rectangle in Figure 1A. The configuration (a rectangle in this example) is chosen so that an applied magnetic field, perpendicular to the slab, increases the current line trajectory (see Figure 1B). The magnetic field perpendicular to the plane of the rectangle thus lengthens the current flow lines. The longer length leads to higher electrical resistance, so long as the resulting lateral voltage difference is electrically shorted, as shown, by the top and bottom edge electrodes.

The best configuration for this effect to occur is one where the current-injecting electrodes are along the longest side of the rectangle, and the ratio of this dimension ("width") to the shortest dimension ("length") is as large as possible. For the present invention, the length of the short edges of the rectangular sensing area is preferably about 30% - 50% of the length of the long edges of the rectangular sensing area. Such an optimal device configuration hence leads to a very low resistance. Kataoka teaches that the magnetic field sensitivity of such devices is best when the devices are made out of semi-conductors with as large a carrier mobility as possible. The resistivity of such devices is made less temperature-dependent when the semi-conductor material contains a large donor concentration, giving a large carrier density. These last two constraints imply that semi-conductors with high electrical conductivity are best suited for practical applications.

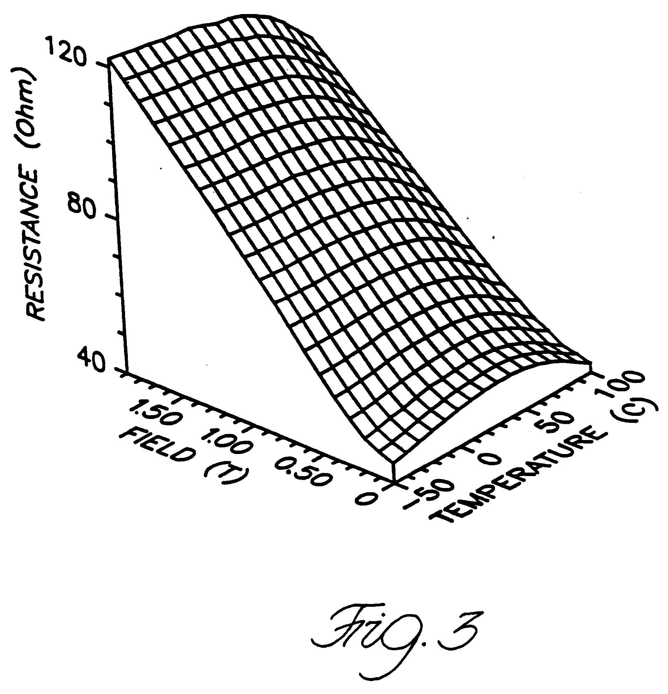

Combined with the geometrical restrictions described earlier, one can deduce that the final magnetoresistor element will have a low resistance. This has a practical drawback. Under a constant voltage, the power dissipated by the device is proportional to the inverse of the resistance. To limit ohmic heating (which would limit the operational temperature range of the sensor, if not destroy the sensor itself) whilst maintaining a large voltage output during sensor interrogation, it is desirable that a magnetoresistive element have a resistance around 1 kilohm. The inventors consider this to typically be equivalent to a resistance of about 300 ohm-3 kilohm. A number of ways have been proposed to achieve such resistances. For example, as Kataoka has pointed out, one can put a number of elementary devices in series. Making a plurality of sensing areas as integral parts of a single element is shown in Figure 2. Whilst only two sensing areas (i.e., devices) are shown, one could make an element with tens or hundreds of integral sensing areas (i.e., devices).

If the metal-semi-conductor (magnetic-field independent) interfacial contact resistance of one such elementary device is an appreciable fraction of the semi-conductor resistance of this elementary device, it will lower the sensitivity to a magnetic field. Thus, metals must be deposited which have a very low metal-semi-conductor interfacial contact resistance to avoid this sensitivity degradation. In most cases it would be preferable that the interfacial contact resistance between the sensing area and its electrodes be 10-100 times less than the resistance of the sensing area between those electrodes. Another option which alleviates the problem of low magnetoresistor device resistance has been to use active layers that are as thin as possible. This has been done by thinning wafers of indium antimonide (InSb), which were sliced from bulk ingots, down to thicknesses as small as 10 micrometres. The wafer thinning process is a very difficult process, since any residual damage from the thinning process will lower the electron mobility. Reducing electron mobility will decrease the sensitivity to a magnetic field of devices made from this material.

Another approach has been to deposit films of InSb onto an insulating substrate. On the other hand, in this latter case, the electron mobility of the resulting films is reduced to a fraction of that of bulk InSb. This reduction occurs because of defects in the film. With typical mobilities of 20,000 $cm^2V^{-1}sec^{-1}$, these films produce devices with greatly reduced sensitivity to a magnetic field compared to devices made from bulk InSb. The usual device structure for the prior magnetoresistors made from a film is schematically shown in Figure 2.

The great majority of the prior work until now has focused on InSb. This can be understood from the data in the following Table I.

## TABLE I.

### Potential Magnetoresistor Materials at $300^{\circ}$K

| Semi-conductive Material | Maximum Electron Mobility $(\mathrm{cm}^2\mathrm{V}^{-1}\mathrm{sec}^{-1})$ | Crystal Lattice Constant (A) | Energy Band Gap (eV) |
|---|---|---|---|
| InSb | 78,000 | 6.478 | 0.17 |
| $\mathrm{Bi}_{1-x}\mathrm{Sb}_x$ (x` 0.2) | 32,000 | 6.429(Bi) | 0-0.02 |
| InAs | 32,000 | 6.058 | 0.35 |
| $\mathrm{In}_{0.53}\mathrm{Ga}_{0.47}\mathrm{As}$ (on InP) | 14,000 | 5.869 | 0.75 |
| GaAs | 8,000 | 5.654 | 1.4 |
| GaSb | 5,000 | 6.095 | 0.68 |
| InP | 4,500 | 5.869 | 1.27 |

Since the magnetoresistance effect is proportional to the square of the electron mobility for small magnetic fields, InSb is highly preferable. However, the difficulty of growing compound semi-conductors in general, and the fact that there is no suitable, lattice-matched, insulating substrate upon which it may be grown led the inventors to try growing Bi films. Such work has been previously reported by Partin et al. in Physical Reviews B, 38, 3818-3824 (1988) and by Heremans et al. in Physical Reviews B, 38, 10280-10284 (1988). Although the inventors succeeded in growing the first epitaxial Bi thin films, with mobilities as high as 25,000 $\mathrm{cm}^2\mathrm{V}^{-1}$ sec$^{-1}$ at 300°K (and 27,000 $\mathrm{cm}^2\mathrm{V}^{-1}$sec$^{-1}$ for $\mathrm{Bi}_{1-x}\mathrm{Sb}_x$ at 300°K), magnetoresistors made from these films had very low sensitivities. Modelling studies which the inventors have just completed indicate that this is to their knowledge an unrecognized effect of the fact that the energy band structure of Bi has several degenerate conduction band minima. Other high-mobility materials shown in Table I have a single, non-degenerate conduction band minimum. The inventors then began growing InSb thin films (on semi-insulating GaAs substrates) using the metal organic chemical vapor deposition (MOCVD) growth technique. After many months of effort, the inventors could only produce films with electron mobilities of 5,000 $\mathrm{cm}^2\mathrm{V}^{-1}$sec$^{-1}$.

The inventors then tried growing Indium Arsenide (InAs) on semi-insulating GaAs, and also on semi-insulating InP substrates. By "semi-insulating" is meant substrates of such high resistivity that they can be considered as substantially insulating. These latter substrates were made semi-insulating by doping them with Fe. They were tried in addition to GaAs because there is less lattice mismatch with InAs (see Table I). After some time, the inventors were able to produce InAs films with a room temperature mobility of 13,000 $\mathrm{cm}^2\mathrm{V}^{-1}$sec$^{-1}$ on InP substrates, and of lower mobility on GaAs substrates. The better InAs films were formed by the following process.

An MOCVD reactor manufactured by Emcore Corporation, U.S.A. was used. InP substrates were heated to the growth temperature in an atmosphere of 5333 Pa (40 torr) of high purity (palladium-diffused) hydrogen to which a moderate quantity of arsine was added (80 SCCM, or standard cubic centimetres per minute). This produced about 0.02 mole fraction of arsine. The arsine was used to retard thermal decomposition of the InP surface caused by loss of the more volatile phosphorus. The way in which arsine reduces the surface roughening during this process is not well understood. Phosphine would have been preferred, but was not available at the time in the reactor. After reaching a temperature of 600°C., the arsine flow was reduced to 7 SCCM, and ethyl-dimethyl indium (EDMIn) was introduced into the growth chamber by bubbling high purity hydrogen (100 SCCM) through EDMIn which was held at 40°C. Higher or lower arsine flows during growth gave lower mobilities and worse surface morphologies. After 2.5 hours of InAs growth time, the EDMIn flow to the growth chamber was stopped and the samples were cooled to room temperature in an arsine-rich atmosphere (as during heat-up).

The thickness of the resulting InAs film was 2.3 micrometres. From conventional Hall effect measurements at 300°K, the electron density was $1.4\mathrm{x}10^{16}$ cm$^{-3}$ and the electron mobility was 13,000 $\mathrm{cm}^2\mathrm{V}^{-1}$sec$^{-1}$. These

are effectively averages since the electron density and mobility may vary within a film. The film was not intentionally doped. Even though this is a very disappointing mobility, a crude magnetoresistor was made, since this required very little effort. A rectangular sample was cleaved from the growth and In metal was hand-soldered along two opposing edges of the sample, and leads were connected to the In metal. The length, which is the vertical dimension in Figures 1A and 1B, was 2 mm and the width, which was the horizontal dimension in Figures 1A and 1B, was 5 mm.

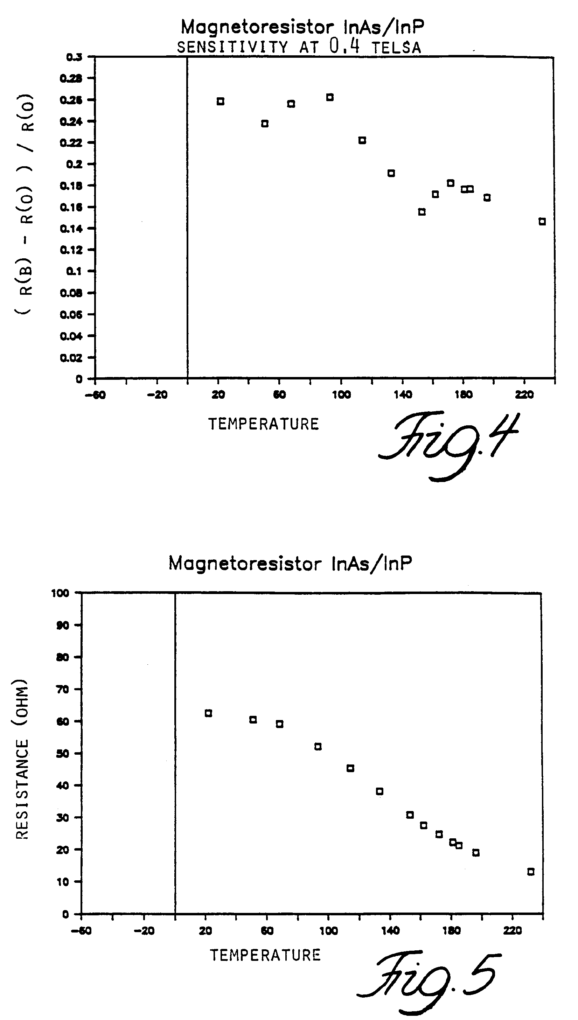

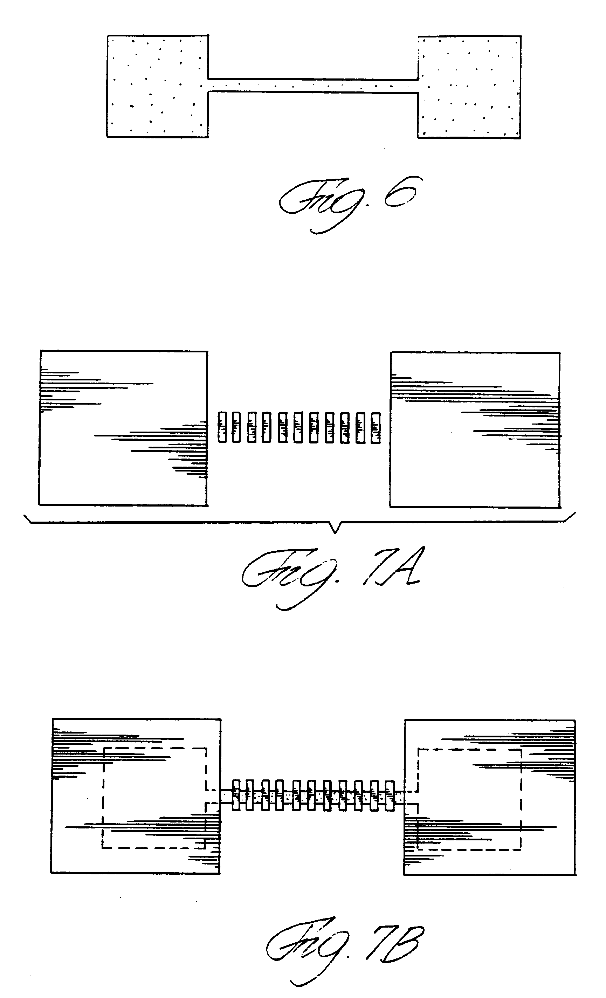

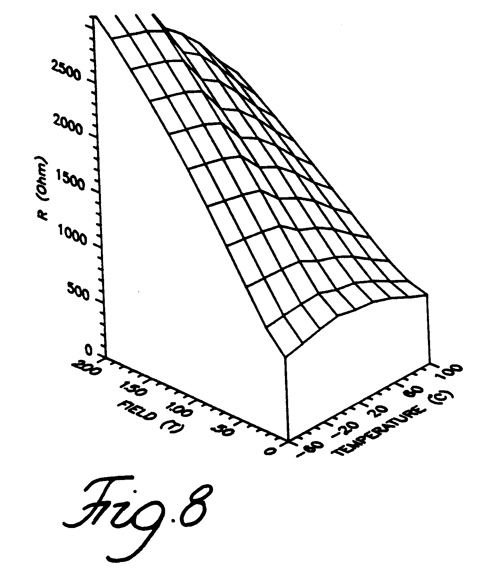

As expected, the resistance of the device was low (about 50 ohm) since the inventors did not have many elements in series. However, the magnetoresistance effect was large. It is shown in Figure 3. Furthermore, the device resistance and magnetoresistance were surprisingly stable with temperature in the range shown in Figure 3, which is -50°C. to +100°C. A second, similar device was tested less thoroughly at temperatures as high as +230°C. The results of this latter testing are shown in Figures 4 and 5. In Figure 4, the applied magnetic field was 0.4 Tesla. The fractional magnetoresistance is plotted as a function of temperature between B = 0.4 Tesla and B = 0. Despite the fact that the indium metal used for contacts has a melting point of 156°C., the magnetoresistor still functioned very surprisingly well at 230°C., with the fractional increase in resistance for a given magnetic field (0.4 Tesla) reduced by less than one half compared to the response near room temperature (as shown in Figure 4).

The device resistance in zero magnetic field, R(0), decreased over the same temperature range by a factor of 5 (as shown in Figure 5). The inventors also found this to be surprisingly good, even taking into account the relatively large energy gap of InAs.

The inventors own detailed analysis of transport data from these films suggests that there are current carriers with two different mobilities present. In retrospect, it looks like the results are related to an accumulation layer of electrons at the surface of the sensing layer. The inventors have now found that Wieder has reported in Appl. Phys. Letters, 25,206 (1974) that such an accumulation layer exists just inside the InAs near the air/InAs interface. It appears to the inventors that there are some errors in the Weider report. However, the inventors think that the basic conclusion that an electron accumulation layer exists is correct. These electrons are spatially separated from the positive charge at the air/InAs interface. Thus, they are scattered relatively little by this charge, resulting in a higher mobility than would normally be the case. They also exist in a very high density in such an accumulation layer, so that, as the temperature increases, the density of thermally-generated carriers is a relatively small fraction of the density in the accumulation layer. This helps stabilize the resistance (at zero magnetic field) with temperature. Thus, it appears that the relatively low measured electron mobility of 13,000 $cm^2V^{-1}sec^{-1}$ is an average for electrons in the accumulation layer and for those in the remainder of the thickness of the film.

Thus, normally one would want to grow a relatively thick layer of InAs to make a good magnetoresistor, since crystal quality (and mobility) generally improve with thickness when growing on a lattice-mismatched substrate. However, the thicker the layer becomes, the greater its conductivity becomes and the less apparent the benefits or presence of a surface accumulation layer would be. Thus, the inventors current understanding of their devices suggests that relatively thinner layers are preferable, even if the average film mobility decreases somewhat, since this will make the conductivity of the surface accumulation layer a greater fraction of the total film conductivity. In a preferred method of making such a sensor using an indium phosphate substrate, a metal organic chemical vapor technique is used to deposit a nominally undoped monocrystalline film of induim arsenide onto said substrate to a thickness of less than 5 micrometres. Preferably this preferred method also includes exposing said deposited film to air. The monocrystalline indium arsenide film in the magnetoresistive sensor of the present invention is approximately 1-3 micrometres thick, and has an average electron density of the order of $10^{16}$ electrons per cubic centimetre and an average electron mobility of about 10,000 - 15,000 $cm^2 V^{-1}$ second $^{-1}$. The exact relationships between film thickness, crystal quality and properties of the surface accumulation layer are currently under study.

The inventors have since made multi-element magnetoresistors from this material using Au (or Sn) metallization. Such multi-element magnetoresistor usually contain over ten discrete sensing areas. First, conventional photolithography techniques were used to etch away unwanted areas of an Indium Arsenide (InAs) film from the surface of the Indium Phosphide (InP) substrate to delineate the pattern shown in Figure 6. A dilute solution (0.5%) of bromine in methanol was used to etch the InAs. Then, a blanket layer of Au metallization 100 nanometres (1000 Angstroms) thick was deposited using conventional vacuum evaporation techniques over the entire surface of the sample, after removing the photoresist. Conventional photolithography was then used to etch away unwanted areas of the Au film to delineate the gold pattern shown in Figure 7A. A dilute aqueous solution of KCN was used for this step. (The inventors think dissolved oxygen is helpful, which can diffuse into the solution from ambient air or be supplied in the form of a very small addition of hydrogen peroxide). The resultant composite of the two patterns, with the gold pattern overlying the InAs film pattern, is shown in Figure 7B.

Leads were then attached by silver epoxy resin to the large Au end bonding pads. Leads could also be attached by normal and accepted filamentary wire-bonding techniques. If so, and especially if a modern wire-bonding apparatus were used, the bonding pads could easily be made much smaller. Also, many devices such as shown in Figures 6, 7A and 7B could be made simultaneously using conventional integrated circuit technology. The resulting devices typically have a resistance near 1 kilohm (typically + or - 20%) at room temperature in zero magnetic field. Surprisingly, the magnetoresistance effect on the multi-sensing area device was much larger than the effect on a single sensing area device. For comparison of these effects at a given magnetic field, see Figures 8 and 3. In the multi-element device (i.e., plural sensing area element), the sensing areas had a length to width ratio of 2/5. The inventors do not understand why the multi-element device works better since the length to width ratio of each element is 2/5, the same as for the single element device characterized in Figure 3, which was fabricated using part of the same InAs grown layer. Another multi-element magnetoresistor was made similarly to the one just described, but with a length to width ratio of 4/5. It had nearly as large a magnetoresistance as the one made according to the patterns in Figures 6, 7A and 7B. Again, the inventors do not yet understand this, but the resulting devices work very well. Even a device with a length to width ratio of 6/5 works well.

The relative stability of these magnetoresistors with temperature also now appears to be increasingly important, since some automotive applications require operation from -50°C to as high as +170°C to +200°C, and there are known applications requiring even higher temperatures (to 300°C). There is reason to believe that the present invention will provide magnetoresistors operating at temperature as high as 300°C, and even higher.

A potential problem with InAs magnetoresistors made in accordance with this invention is the potential importance of the air/InAs interface, which might cause the device characteristics to be sensitive to changes in the composition of ambient air, or cause the characteristics to slowly change with time or thermal history because of continued oxidation of the surface. A preferred sensor according to this invention is one in which there is a protective but gas-permeable coating over each sensing area of the sensor. Preferably such a coating is permeable to ambient air. The inventors have tried coating the surfaces of two devices with a particular epoxy resin made by Emerson and Cuming, a division of Grace Co. U.S.A. The epoxy resin used was "Stycast", number 1267. Parts A and B were mixed, applied to the devices, and cured at 70°C for two hours. The inventors did not observe any significant changes in the device characteristics at room temperature as a result of this encapsulation process. The inventors have not yet systematically tested these devices at other temperatures, but they are encouraged by this preliminary result. The inventors think other forms of encapsulants need to be explored, such as other epoxy resins and thin film dielectrics, such as $SiO_2$ or $Si_3N_4$.

In order to still have a very low metal-semi-conductor contact resistance between the InAs and the contact and shorting bar metallization, it may be necessary to modify the processing sequence previously described in connection with Figures 6, 7A and 7B. For example, with an inverse of the mask contemplated in the previous discussion, the photoresist on the surface could then be used as a mask for wet-etching (e.g., by wet chemicals or reactive ions, or ion beams) of the dielectric or high energy gap semi-conductor layer to expose the InAs. Au or other metals could then be deposited by vacuum evaporation (or by other conventional processes, such as sputtering, or electroplating) and then the photoresist could be removed, resulting in lift-off of the undesired regions of metal. Alternatively, after etching through to the InAs, the photoresist could be removed, Au or other metal could be deposited uniformly across the surface, and then, after deposition of photoresist, the mask pattern in Figure 7A could be aligned with the pattern etched into the dielectric and the Au could be patterned as before.

As an additional alternative, if a sufficiently thin layer (e.g., 20 nanometres (200 Angstroms)) of high energy gap semi-conductor is present, the original processing sequence described could be modified by deposition of a low-melting-temperature eutectic alloy, such as Au-Ge, Au-Ge-Ni, or Ag-Sn, in place of Au. After patterning similarly to the way the Au was patterned (or using the inverse of the mask in Figure 7A and lift-off), the sample is heated to a moderate temperature, typically to somewhere in the range of 360°C to 500°C for Au-Ge-based alloys, thus allowing the liquid metal to locally dissolve the thin layer of high energy gap semi-conductor, effectively contacting the InAs.

In the most recent work, the inventors have changed the InAs growth procedures somewhat. The procedures are the same as before, but the InP wafer is heated to 460°C in a larger arsine mole fraction (0.1). After 0.5 minutes at 460°C, during which the native oxide on InP is believed to desorb, the temperature is lowered to 400°C. and 20 nanometres (200 Angstroms), of InAs in thickness is grown. The temperature is then raised to the growth temperature of 625°C (with the arsine mole fraction still 0.1), and then EDMIn is introduced while the arsine flow is abruptly reduced to 5 SCCM (about 0.001 mole fraction). The EDMIn is kept at 50°C, and the high purity hydrogen is kept bubbling through it at a rate of 75 SCCM. Again, the arsine flow of 5 SCCM seems near-optimal for these growth conditions. The resulting films have somewhat enhanced sensitivity to a magnetic field relative to those grown earlier.

Whilst all of the recent work has concentrated on magnetoresistors fabricated from InAs films on semi-insulating (i.e., substantially electrically insulating) InP substrates, the inventors think that a more mature growth capability will permit films of InAs with nearly comparable quality to be grown on semi-insulating GaAs substrates as well. In either case, other growth techniques such as molecular beam epitaxy, liquid phase epitaxy or chloride-transport vapor phase epitaxy may also prove useful.

The inventors think that these types of magnetoresistors are especially attractive for automotive applications as part of linear or rotary position magnetic measurement systems.

Also, the inventors are convinced that the presence of an accumulation layer in the above-mentioned thin film InAs magnetoresistors is what makes them work so well, and which enables production of a practical device. The inventors believe that the accumulation layer is naturally occurring in the fabrication process. The fundamental concept of incorporating and using an accumulation layer in a magnetoresistor is believed to be new. It is also believed that this concept can be expanded in a multiplicity of ways, not only with Indium Arsenide magnetoresistor films, but expanded to other semi-conductive materials as well. The concept of specifically inducing an accumulation layer in indium arsenide film magnetoresistors and in magnetoresistors of other semiconductor materials is believed to be new. Inducing the accumulation layer by a variety of techniques is described and claimed in the European patent application EP-A- 0 375 107, filed at the same date as the present application and based upon US-A- 4 978 938.

The use of an indium arsenide magnetoresistor according to the present invention in a specific magnetic sensing circuit is being claimed in the earlier filed European patent applications EP-A- 0 357 199 and EP-A- 0 357 200, based upon US-A- 4 926 122 and US-A- 4 939 456.

## Claims

1. A sensor providing electrical output voltage changes in response to changes in an applied magnetic field, said sensor comprising: a substrate and a thin film of monocrystalline indium arsenide disposed on said substrate, said thin film having a face opposite its interface with said substrate; said monocrystalline indium arsenide film including a substantially rectangular sensing area for sensing a magnetic field applied perpendicularly to said film, said sensing area having conductor means along opposed long edges of said area in low electrical resistance contact with film portions adjacent the film face; characterised in that said monocrystalline indium arsenide film is approximately 1-3 micrometres thick and is essentially undoped, and has an average electron density of the order of $10^{16}$ electrons per cubic centimetre and an average electron mobility of at least 10,000 - 15,000 $cm^2$ $volt^{-1}$ $second^{-1}$ but which also has a current carrier accumulation layer adjacent said face that enhances magnetic sensitivity of said film and provides unamplified identifiable electrical output voltage changes in response to changes in said applied magnetic field even when exposed up to temperatures as high as 300°C.

2. A sensor according to claim 1, in which the sensing rectangle has short edges of a length that is 30% - 50% of the length of the long edges.

3. A sensor according to claim 1 or 2, in which the substrate is a substantially electrically-insulating monocrystalline indium phosphide substrate.

4. A sensor according to claim 1, 2 or 3, in which said substrate supports a plurality of said thin film sensing areas, and said sensing areas are electrically in series with one another.

5. A sensor according to claim 1, 2 or 3, in which said monocrystalline indium arsenide film has an elongated portion, the elongated portion comprises a plurality of successive sensing areas, each successive sensing area extends across the width of the elongated portion, the sensing areas are electrically in series with one another, and a conductive coating extends completely across said elongated portion between adjacent ones of the said successive sensing areas, whereby power consumption of said sensor is significantly reduced but sensor size is not significantly increased.

6. A sensor according to claim 1, in which said substrate is a substrate having a thermal expansion characteristic close to that of indium arsenide and having a surface that is substantially electrically insulating and monocrystalline, and which contains few crystal defects and has a crystal lattice constant close to

EP 0 375 108 B1

that of indium arsenide, and the electron accumulation layer has an electron density at least an order of magnitude higher than said average electron density and an apparent electron mobility greater than said average electron mobility and which is effective to provide a magnetic sensitivity and range of operating temperature corresponding to an indium arsenide thin film that is thinner and has a higher electron density and electron mobility.

7. A sensor according to claim 6, in which said monocrystalline indium arsenide film has an elongated portion, the elongated portion comprises a plurality of successive sensing areas, each successive sensing area extends across the width of the elongated portion, the sensing areas are electrically in series with one another, and a conductive coating extends completely across said elongated portion between adjacent ones of said successive sensing areas, whereby power consumption of said sensor is reduced without correspondingly increasing sensor size.

8. A sensor according to claim 7, in which there are over ten of said sensing areas.

9. A sensor according to any one of claims 6 to 8, in which there is a protective but gas-permeable coating on said film over each sensing area.


## Patentansprüche

1. Ein Sensor, der elektrische Ausgangsspannungsänderungen in Abhängigkeit von Änderungen in einem angelegten Magnetfeldes vorsieht, wobei der Sensor umfaßt: ein Substrat und einen dünnen Film aus monokristallinem Indium-Arsenid, der auf dem Substrat angeordnet ist, wobei der dünne Film eine Seite entgegengesetzt seiner Grenzfläche mit dem Substrat aufweist; der monokristalline Indium-Arsenid-Film eine im wesentlichen rechteckige erfassende Fläche zum Erfassen eines Magnetfeldes umfaßt, das senkrecht zu dem Film angelegt wird, wobei die erfassende Fläche ein Halbleitermittel längs gegenüberliegender langer Ränder der Fläche in Kontakt mit niedrigem elektrischen Widerstand mit Filmteilen benachbart der Filmseite aufweist; dadurch gekennzeichnet, daß der monokristalline Indium-Arsenid-Film näherungsweise 1-3 Mikrometer dick und im wesentlichen undotiert ist und eine Durchschnittselektronendichte von der Größenordnung von $10^{16}$ Elektronen pro Kubikzentimeter und eine Durchschnittselektronenmobilität von zumindest 10.000-15.000 $cm^2$ $Volt^{-1}$ $Sekunde^{-1}$ aufweist, aber welcher auch eine Stromträgeranreicherungsschicht benachbart der Seite aufweist, die die magnetische Empfindlichkeit des Filmes verstärkt und unverstärkte identifizierbare elektrische Ausgangsspannungsänderungen in Abhängigkeit von Änderungen in einem angelegten Magnetfeldes vorsieht, und zwar selbst dann, wenn er Temperaturen so hoch wie 300°C ausgesetzt ist.

2. Ein Sensor nach Anspruch 1, in welchem das erfassende Rechteck kurze Ränder von einer Länge aufweist, die 30 % - 50 % der Länge der langen Ränder beträgt.

3. Ein Sensor nach Anspruch 1 oder 2, in welchem das Substrat ein im wesentlichen elektrisch isolierendes monokristallines Indium-Phosphid-Substrat ist.

4. Ein Sensor nach Anspruch 1, 2 oder 3, in welchem das Substrat eine Vielzahl der erfassenden Dünnfilm-Flächen aufweist und die erfassenden Flächen sich elektrisch in Reihe miteinander befinden.

5. Ein Sensor nach Anspruch 1, 2 oder 3, in welchem der monokristalline Indium-Arsenid-Film einen länglichen Teil aufweist, der längliche Teil eine Vielzahl von aufeinanderfolgenden erfassenden Flächen umfaßt, jede sukzessive erfassende Fläche sich über die Breite des länglichen Teils erstreckt, die erfassenden Flächen sich elektrisch miteinander in Reihe befinden und ein leitender Überzug sich vollständig über den länglichen Teil zwischen benachbarten der sukzessiven erfassenden Flächen erstreckt, wodurch der Leistungsverbrauch des Sensors signifikant verringert wird, aber die Sensorgröße nicht signifikant erhöht wird.

6. Ein Sensor nach Anspruch 1, in welchem das Substrat ein Substrat ist, das eine thermische Ausdehnungscharakteristik nahe zu jener von Indium-Arsenid aufweist und eine Oberfläche aufweist, die im wesentlichen elektrisch isolierend und monokristallin ist, und welches wenige Kristalldefekte aufweist und eine Kristallgitterkonstante nahe zu jener von Indium-Arsenid aufweist, und die Elektronenanreicherungsschicht eine Elektronendichte zumindest eine Größenordnung höher als die Durchschnittselektronendich-

8

te und eine scheinbare Elektronenmobilität größer als die Durchschnittselektronenmobilität aufweist, und welche wirksam ist, um eine magnetische Empfindlichkeit und einen Bereich der Betriebstemperatur entsprechend zu einem Indium-Arsenid-Dünnfilm vorzusehen, der dünner ist und eine höhere Elektronendichte und Elektronenmobilität aufweist.

7. Ein Sensor nach Anspruch 6, in welchem der monokristalline Indium-Arsenid-Film einen länglichen Teil aufweist, der längliche Teil eine Vielzahl von sukzessiven erfassenden Flächen umfaßt, jede sukzessive erfassende Fläche sich über die Breite des länglichen Teils erstreckt, die erfassenden Flächen sich elektrisch miteinander in Reihe befinden und ein leitender Überzug sich vollständig über den länglichen Teil zwischen benachbarten der sukzessiven erfassenden Flächen erstreckt, wodurch der Leistungsverbrauch des Sensors verringert wird, ohne die Sensorgröße entsprechend zu erhöhen.

8. Ein Sensor nach Anspruch 7, in welchem es mehr als zehn der erfassenden Flächen gibt.

9. Ein Sensor nach einem der Ansprüche 6 bis 8, in welchem es einen schützenden, aber gaspermeablen Überzug auf dem Film über jeder erfassenden Fläche gibt.

**Revendications**

1. Capteur fournissant des variations de tension électrique de sortie en réponse à des variations d'un champ magnétique appliqué, ledit capteur comprenant: un substrat et une couche mince d'arséniure d'indium monocristallin disposée sur ledit substrat, ladite couche mince ayant une face en regard de son interface avec ledit substrat ; ladite couche d'arséniure d'indium monocristallin comprenant une zone de détection de forme sensiblement rectangulaire pour détecter un champ magnétique appliqué perpendiculairement à ladite couche, ladite zone de détection ayant des moyens de conducteur le long de bords opposés de ladite zone dans un contact de faible résistance électrique, avec des portions de couches adjacentes à la face de film ; caractérisé en ce que ladite couche d'arséniure d'indium monocristallin a une épaisseur d'environ 1-3 micromètres et est essentiellement non dopée, et a une densité moyenne d'électrons de l'ordre de $10^{16}$ électrons par centimètre cube et une mobilité moyenne d'électrons d'au moins 10 000 à 15 000 cm$^2$ volt$^{-1}$ seconde$^{-1}$, mais qui a aussi une couche d'accumulation de porteurs de courant adjacente à ladite face qui augmente la sensibilité magnétique de ladite couche et fournit des variations identifiables non amplifiées de tension électrique de sortie en réponse à des variations dudit champ magnétique appliqué, même si elle est exposée à une température atteignant 300° C.

2. Capteur selon la revendication 1, dans lequel le rectangle de détection a des côtés courts d'un longueur qui est égale à 30 % - 50 % de la longueur des côtés longs.

3. Capteur selon la revendication 1 ou 2, dans lequel le substrat est un substrat en phosphure d'indium monocristallin pratiquement isolant électriquement.

4. Capteur selon la revendication 1, 2 ou 3, dans lequel ledit substrat supporte une pluralité desdites zones de détection de couche mince, et lesdites zones de détection sont branchées électriquement en série les unes avec les autres.

5. Capteur selon la revendication 1, 2 ou 3, dans lequel ladite couche d'arséniure d'indium monocristallin a une portion allongée, la portion allongée comprenant une pluralité de zones successives de détection, chaque zone successive de détection s'étendant sur la largeur de la portion allongée, les zones de détection étant branchées électriquement en série les unes avec les autres, et un revêtement conducteur s'étendant complètement sur ladite portion allongée entre des zones adjacentes desdites zones successives de détection, au moyen de quoi la consommation d'énergie dudit capteur est fortement réduite mais la dimension du capteur n'est pas sensiblement augmentée.

6. Capteur selon la revendication 1, dans lequel ledit substrat est un substrat ayant une caractéristique de dilatation thermique proche de celle de l'arséniure d'indium et ayant une surface qui est pratiquement électriquement isolante et monocristalline, et qui contient peu de défauts cristallins et a une constante de réseau cristallin proche de celle de l'arséniure d'indium, et la couche d'accumulation d'électrons a une densité d'électrons supérieure d'au moins un ordre de grandeur à ladite densité moyenne d'électrons et une mobilité apparente d'électrons supérieure à ladite mobilité moyenne d'électrons et qui est efficace pour fournir une sensibilité magnétique et une gamme de températures de fonctionnement correspondant à une couche mince d'arséniure d'indium qui est plus mince et a une densité d'électrons et une mobilité d'électrons plus élevées.

7. Capteur selon la revendication 6, dans lequel ladite couche d'arséniure d'indium monocristallin a une portion allongée, la portion allongée comprenant une pluralité de zones successives de détection, chaque zone successive de détection s'étendant sur la largeur de la portion allongée, les zones de détection étant branchées électriquement en série les unes avec les autres, et un revêtement conducteur s'étendant complètement sur ladite portion allongée entre des zones adjacentes desdites zones successives de détection, au moyen de quoi la consommation d'énergie dudit capteur est réduite sans un accroissement correspondant de la dimension du capteur.

8. Capteur selon la revendication 7, dans lequel il existe plus de dix desdites zones de détection.

9. Capteur selon l'une quelconque des revendications 6 à 8, dans lequel il existe un revêtement protecteur mais perméable aux gaz sur ladite couche au-dessus de chaque zone de détection.

*Fig. 1A*

*Fig. 1B*

*Fig. 2*

Semiconductor
Epitaxial Layer

Metal

Electrons

Contacts

High Mobility
Semiconductor
Layer

Insulating
Substrate

Magnetic Field

*Fig. 3*

Magnetoresistor InAs/InP
SENSITIVITY AT 0.4 TELSA

*Fig.4*

Magnetoresistor InAs/InP

*Fig.5*

Fig. 6

Fig. 7A

Fig. 7B

Fig.8